# EUROPEAN PATENT SPECIFICATION

(11) **EP 3 549 942 B1**
(45) Date of publication and mention of the grant of the patent: **01.10.2025**
(21) Application number: 18805218.7
(22) Date of filing: 14.05.2018
(51) Int. Cl.: H10K 85/10, H10K 85/40, H10K 30/20, C07F 7/18

(54) **COMPOUND AND ORGANIC SOLAR CELL COMPRISING SAME**
VERBINDUNG UND ORGANISCHE SOLARZELLE DAMIT
COMPOSÉ ET CELLULE SOLAIRE ORGANIQUE LE COMPRENANT

(30) Priority: 24.05.2017 KR 20170064106
(43) Date of publication of application: 09.10.2019
(73) Proprietor: LG Chem, Ltd., Seoul 07336 (KR)
(72) Inventor: LIM, Bogyu, Daejeon 34122 (KR); JANG, Songrim, Daejeon 34122 (KR); CHOI, Doowhan, Daejeon 34122 (KR); KIM, Ji Hoon, Daejeon 34122 (KR)
(74) Representative: Hoffmann Eitle
(86) International application number: PCT/KR2018/005489
(87) International publication number: WO 2018/216936

(56) References cited:
- EP-A1- 1 717 258
- EP-A1- 3 048 123
- EP-A2- 3 290 422
- KR-A- 20060 134 068
- KR-A- 20160 128 227
- KR-A- 20160 128 227
- US-A1- 2015 361 223
- CHANGSIK SONG ET AL: "Highly Conductive Poly(phenylene thienylene)s:? m -Phenylene Linkages Are Not Always Bad", MACROMOLECULES, vol. 38, no. 11, 1 May 2005 (2005-05-01), WASHINGTON, DC, UNITED STATES, pages 4569 - 4576, XP055340992, ISSN: 0024-9297, DOI: 10.1021/ma0501702
- SONG, C. ET AL.: "Highly Conductive Poly(phenylene thienylene)s: m-Phenylene Linkages Are Not Always Bad", MACROMOLECULES, vol. 38, 2005, pages 4569 - 4576, XP055340992
- MASUYAMA, K. ET AL.: "Time-Resolved Photoluminescence Study and Microcapillary Laser of Blue-Emissive pi-Conjugated Polymers Based on 9,10-Dihydrophenanthrene Uni t", JAPANESE JOURNAL OF APPLIED PHYSICS, vol. 48, 2009, pages 082404, XP055559402
- KO, H. C. ET AL.: "Multicolored Electrochromism of a Poly {1,4-bis[2-(3,4-ethylenedioxy) thienyl]benzene} Derivative Bearing Viologen Functional Groups", ADVANCED FUNCTIONAL MATERIALS, vol. 15, 2005, pages 905 - 909, XP055559404

## Description

### [Technical Field]

The present specification relates to a compound and an organic solar cell including the same.

### [Background Art]

An organic solar cell is a device which may directly convert solar energy into electric energy by applying a photovoltaic effect. A solar cell may be divided into an inorganic solar cell and an organic solar cell, depending on the materials constituting a thin film. Typical solar cells are made through a p-n junction by doping crystalline silicon (Si), which is an inorganic semiconductor. Electrons and holes generated by absorbing light diffuse to p-n junction points and move to an electrode while being accelerated by the electric field. The power conversion efficiency in this process is defined as the ratio of electric power given to an external circuit and solar power entering the solar cell, and the efficiency have reached approximately 24% when measured under a currently standardized virtual solar irradiation condition. However, since inorganic solar cells in the related art have already shown the limitation in economic feasibility and material demands and supplies, an organic semiconductor solar cell, which is easily processed and inexpensive and has various functionalities, has come into the spotlight as a long-term alternative energy source.

For the solar cell, it is important to increase efficiency so as to output as much electric energy as possible from solar energy. In order to increase the efficiency of the solar cell, it is important to generate as many excitons as possible inside a semiconductor, but it is also important to pull the generated charges to the outside without loss. One of the reasons for the charge loss is the dissipation of generated electrons and holes due to recombination. Various methods have been proposed to deliver generated electrons and holes to an electrode without loss, but additional processes are required in most cases, and accordingly, manufacturing costs may be increased.

US-A-2015/0361223 A1 discloses a polymeric material for use in an organic thin-film solar cell. The polymeric material can be

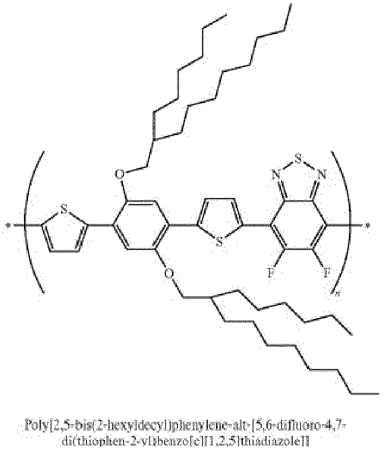

KR 2016 0128227 A; Macromol., 2005, 38, 4569-4576; EP 1 717 258 A1; and EP 3 048 123 A1 also disclose polymeric materials that can be used in thin-film solar cells.

### [Detailed Description of the Invention]

### [Technical Problem]

An object of the present specification is to provide a compound and an organic solar cell including the same.

According to a first aspect, the present invention provides a compound represented by any one of the following Formulae 1-11 to 1-13 and 1-15: 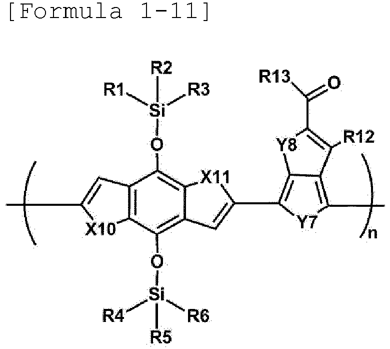 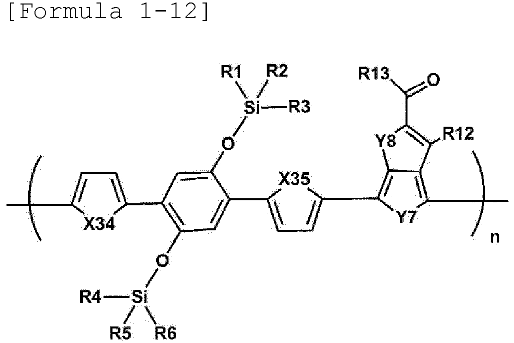 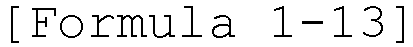 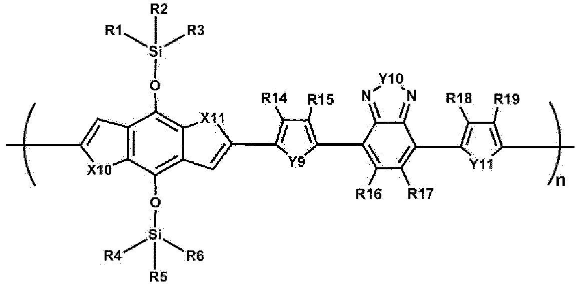 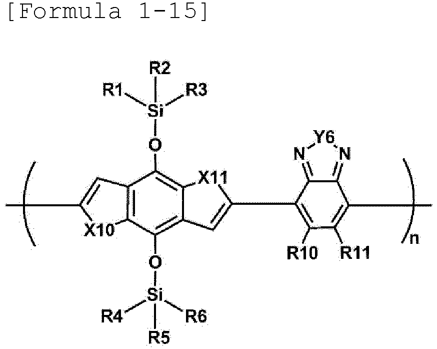 wherein:
R1 to R6 are the same as or different from each other, and are each independently an alkyl group; X10, X11, X34, X35, and Y6 to Y11 are the same as or different from each other, and are each independently S, O, Se, Te, NR, CRR', SiRR', PR', or GeRR'; R10 to R19, R, and R' are the same as or different from each other, and are each independently hydrogen; deuterium; a halogen group; a nitrile group; a nitro group; a hydroxyl group; a carbonyl group; an ester group; an imide group; an amide group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; or a substituted or unsubstituted heterocyclic group; and n is an integer from 1 to 10,000.

According to a second aspect, the present invention provides an organic solar cell including: a first electrode;
a second electrode provided to face the first electrode; and
an organic material layer having one or more layers provided between the first electrode and the second electrode and including a photoactive layer,
in which one or more layers of the organic material layer include the compound according to the above first aspect.

### [Advantageous Effects]

The compound of the present specification may be used as a material for an organic material layer of an organic solar cell, and an organic solar cell including the same may exhibit characteristics which are excellent in an increase in open-circuit voltage and short-circuit current and/or an increase in efficiency, and the like.

The compound according to an exemplary embodiment of the present specification has an improved solubility by introducing a bulky alkyl chain into a side chain, and thus may be used in mixture with another material, and has improved crystallinity, and has an economic advantage in terms of time and/or costs during the manufacture of a device.

### [Brief Description of Drawings]

FIG. 1 is a view illustrating an organic solar cell according to an exemplary embodiment of the present specification.
FIG. 2 is a view illustrating an NMR spectrum of Compound 1-b.
FIG. 3 is a view illustrating an NMR spectrum of Compound 1-c.
FIG. 4 is a view illustrating an NMR spectrum of Compound A-1.
FIG. 5 is a view illustrating an NMR spectrum of Compound 1-e.
FIG. 6 is a view illustrating an MS spectrum of Compound A-2.
FIG. 7 is a view illustrating an NMR spectrum of Compound A-2.
FIG. 8 illustrates a current density according to a voltage with respect to organic solar cells manufactured in exemplary embodiments of the present specification.

101: Substrate
102: First electrode
103: Hole transport layer
104: Photoactive layer
105: Second electrode

### [Best Mode]

Hereinafter, the present specification will be described in detail.

One aspect of the present invention provides the compound represented by any one of the Formulae 1-11 to 1-13 and 1-15.

The compound according to an exemplary embodiment of the present specification implements high efficiency, and simultaneously has an appropriate solubility, and thus may be used in mixture with another material and has improved crystallinity, and has an economic advantage in terms of time and/or costs during the manufacture of a device.

Further, the compound according to an exemplary embodiment of the present specification has high crystallinity, and thus has an effect in that the charge mobility is improved.

When one part "includes" one constituent element in the present specification, unless otherwise specifically described, this does not mean that another constituent element is excluded, but means that another constituent element may be further included.

When one member is disposed "on" another member in the present specification, this includes not only a case where the one member is brought into contact with another member, but also a case where still another member is present between the two members.

In the present specification, the "combination" means that multiple identical structures are linked to each other, or different types of structures are linked to each other.

Examples of the substituents in the present specification will be described below, but are not limited thereto.

In the present specification, 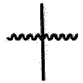 means a moiety bonded to another substituent or a bonding portion.

The term "substitution" means that a hydrogen atom bonded to a carbon atom of a compound is changed into another substituent, and a position to be substituted is not limited as long as the position is a position at which the hydrogen atom is substituted, that is, a position at which the substituent may be substituted, and when two or more are substituted, the two or more substituents may be the same as or different from each other.

In the present specification, the term "substituted or unsubstituted" means being unsubstituted or substituted with one or more substituents selected from the group consisting of deuterium; a halogen group; a nitrile group; a nitro group; a hydroxyl group; a carbonyl group; an ester group; an imide group; an amine group; a phosphine oxide group; an alkoxy group; an aryloxy group; an alkylthioxy group; an arylthioxy group; an alkylsulfoxy group; an arylsulfoxy group; a silyl group; a boron group; an alkyl group; a cycloalkyl group; an alkenyl group; an aryl group; an aralkyl group; an aralkenyl group; an alkylaryl group; an alkylamine group; an aralkylamine group; a heteroarylamine group; an arylamine group; an arylphosphine group; and a heterocyclic group, or being unsubstituted or substituted with a substituent to which two or more substituents are linked among the substituents exemplified above. For example, "the substituent to which two or more substituents are linked" may be a biphenyl group. That is, the biphenyl group may also be an aryl group, and may be interpreted as a substituent to which two phenyl groups are linked.

In the present specification, the number of carbon atoms of a carbonyl group is not particularly limited, but is preferably 1 to 40. Specifically, the carbonyl group may be a compound having the following structures, but is not limited thereto.

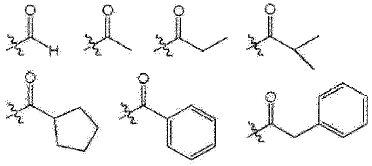

In the present specification, for an ester group, the oxygen of the ester group may be substituted with a straight-chained, branched, or cyclic alkyl group having 1 to 25 carbon atoms, or an aryl group having 6 to 25 carbon atoms. Specifically, the ester group may be a compound having the following structural formulae, but is not limited thereto.

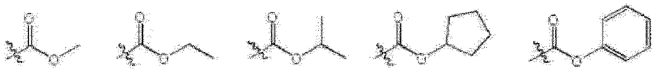

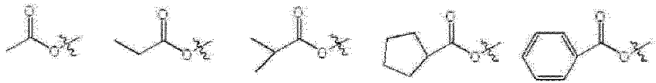

In the present specification, for an amide group, the nitrogen of the amide group may be substituted with hydrogen, a straight-chained, branched, or cyclic alkyl group having 1 to 30 carbon atoms, or an aryl group having 6 to 30 carbon atoms. Specifically, the amide group may be a compound having the following structural formulae, but is not limited thereto.

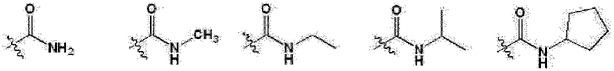

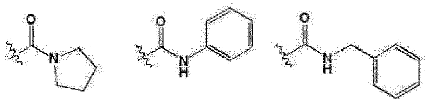

In the present specification, the number of carbon atoms of an imide group is not particularly limited, but is preferably 1 to 25. Specifically, the imide group may be a compound having the following structures, but is not limited thereto.

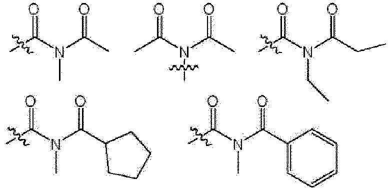

In the present specification, a silyl group may be represented by a formula of -SiRₐR_{b}R_{c}, and Rₐ, R_{b}, and R_{c} may be each hydrogen; a substituted or unsubstituted alkyl group; or a substituted or unsubstituted aryl group. Specific examples of the silyl group include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, and the like, but are not limited thereto.

In the present specification, a boron group may be represented by a formula of -BRₐR_{b}, and Rₐ and R_{b} may be each hydrogen; a substituted or unsubstituted alkyl group; or a substituted or unsubstituted aryl group. Specific examples of the boron group include a trimethylboron group, a triethylboron group, a t-butyldimethylboron group, a triphenylboron group, a phenylboron group, and the like, but are not limited thereto.

In the present specification, examples of a halogen group include fluorine, chlorine, bromine or iodine.

In the present specification, the alkyl group may be straight-chained or branched, and the number of carbon atoms thereof is not particularly limited, but is preferably 1 to 40. According to an exemplary embodiment, the number of carbon atoms of the alkyl group is 1 to 20. According to another exemplary embodiment, the number of carbon atoms of the alkyl group is 1 to 10. According to still another exemplary embodiment, the number of carbon atoms of the alkyl group is 1 to 6. Specific examples of the alkyl group include methyl, ethyl, propyl, n-propyl, isopropyl, butyl, n-butyl, isobutyl, tert-butyl, sec-butyl, 1-methyl-butyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethylpropyl, isohexyl, 4-methylhexyl, 5-methylhexyl, and the like, but are not limited thereto.

In the present specification, the alkenyl group may be straight-chained or branched, and the number of carbon atoms thereof is not particularly limited, but is preferably 2 to 40. According to an exemplary embodiment, the number of carbon atoms of the alkenyl group is 2 to 20. According to another exemplary embodiment, the number of carbon atoms of the alkenyl group is 2 to 10. According to still another exemplary embodiment, the number of carbon atoms of the alkenyl group is 2 to 6. Specific examples thereof include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group, and the like, but are not limited thereto.

In the present specification, a cycloalkyl group is not particularly limited, but has preferably 3 to 60 carbon atoms, and according to an exemplary embodiment, the number of carbon atoms of the cycloalkyl group is 3 to 30. According to another exemplary embodiment, the number of carbon atoms of the cycloalkyl group is 3 to 20. According to still another exemplary embodiment, the number of carbon atoms of the cycloalkyl group is 3 to 6. Specific examples thereof include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl, and the like, but are not limited thereto.

In the present specification, an alkoxy group is not particularly limited, but has preferably 1 to 40 carbon atoms. According to an exemplary embodiment, the number of carbon atoms of the alkoxy group is 1 to 10. According to another exemplary embodiment, the number of carbon atoms of the alkoxy group is 1 to 6. Specific examples of the alkoxy group include a methoxy group, an ethoxy group, a propoxy group, an isobutyloxy group, a sec-butyloxy group, a pentyloxy group, an iso-amyloxy group, a hexyloxy group, and the like, but are not limited thereto.

In the present specification, an amine group may include: an alkylamine group; an aralkylamine group; a heteroarylamine group; and an arylamine group.

In the present specification, the number of carbon atoms of the amine group is not particularly limited, but is preferably 1 to 30. Specific examples of the amine group include a methylamine group, a dimethylamine group, an ethylamine group, a diethylamine group, a phenylamine group, a naphthylamine group, a biphenylamine group, an anthracenylamine group, a 9-methyl-anthracenylamine group, a diphenylamine group, a phenylnaphthylamine group, a ditolylamine group, a phenyltolylamine group, a triphenylamine group, and the like, but are not limited thereto.

In the present specification, examples of the arylamine group include a substituted or unsubstituted monoarylamine group, a substituted or unsubstituted diarylamine group, or a substituted or unsubstituted triarylamine group. The aryl group in the arylamine group may be a monocyclic aryl group or a polycyclic aryl group. The arylamine group including two or more aryl groups may include a monocyclic aryl group, a polycyclic aryl group, or both a monocyclic aryl group and a polycyclic aryl group.

Specific examples of the arylamine group include phenylamine, naphthylamine, biphenylamine, anthracenylamine, 3-methyl-phenylamine, 4-methyl-naphthylamine, 2-methyl-biphenylamine, 9-methyl-anthracenylamine, a diphenylamine group, a phenylnaphthylamine group, a ditolylamine group, a phenyltolylamine group, carbazole, a triphenylamine group, and the like, but are not limited thereto.

In the present specification, examples of an arylphosphine group include a substituted or unsubstituted monoarylphosphine group, a substituted or unsubstituted diarylphosphine group, or a substituted or unsubstituted triarylphosphine group. The aryl group in the arylphosphine group may be a monocyclic aryl group, and may be a polycyclic aryl group. The arylphosphine group including two or more aryl groups may include a monocyclic aryl group, a polycyclic aryl group, or both a monocyclic aryl group and a polycyclic aryl group.

In the present specification, an aryl group is not particularly limited, but has preferably 6 to 60 carbon atoms, and may be a monocyclic aryl group or a polycyclic aryl group. According to an exemplary embodiment, the number of carbon atoms of the aryl group is 6 to 30. According to an exemplary embodiment, the number of carbon atoms of the aryl group is 6 to 20. Examples of the monocyclic aryl group include a phenyl group, a biphenyl group, a terphenyl group, and the like, but are not limited thereto. Examples of the polycyclic aryl group include a naphthyl group, an anthracenyl group, a phenanthryl group, a pyrenyl group, a perylenyl group, a chrysenyl group, a fluorenyl group, a triphenylene group, and the like, but are not limited thereto.

In the present specification, a fluorenyl group may be substituted, and two substituents may be bonded to each other to form a spiro structure.

When the fluorenyl group is substituted, the fluorenyl group may be 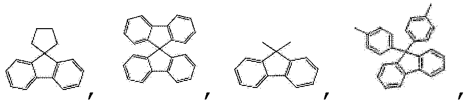 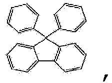 and the like. However, the substituent is not limited thereto.

In the present specification, a heterocyclic group is a heterocyclic group including one or more of N, O, S, Si, and Se as a heteroatom, and the number of carbon atoms thereof is not particularly limited, but is preferably 2 to 60. Examples of the heterocyclic group include a thiophene group, a furan group, a pyrrole group, an imidazole group, a thiazole group, an oxazole group, an oxadiazole group, a triazole group, a pyridyl group, a bipyridyl group, a pyrimidyl group, a triazine group, a triazole group, an acridyl group, a pyridazine group, a pyrazinyl group, a qinolinyl group, a quinazoline group, a quinoxalinyl group, a phthalazinyl group, a pyridopyrimidinyl group, a pyridopyrazinyl group, a pyrazinopyrazinyl group, an isoquinoline group, an indole group, a carbazole group, a benzoxazole group, a benzimidazole group, a benzothiazole group, a benzocarbazole group, a benzothiophene group, a dibenzothiophene group, a benzofuranyl group, a phenanthroline group, a thiazolyl group, an isoxazolyl group, an oxadiazolyl group, a thiadiazolyl group, a phenoxazinyl group, a phenothiazinyl group, a dibenzofuranyl group, and the like, but are not limited thereto. The heterocyclic group may be monocyclic or polycyclic, and includes an aliphatic heterocyclic group and an aromatic heterocyclic group.

In the present specification, examples of the heteroarylamine group include a substituted or unsubstituted monoheteroarylamine group, a substituted or unsubstituted diheteroarylamine group, or a substituted or unsubstituted triheteroarylamine group. The heteroarylamine group including two or more heteroaryl groups may include a monocyclic heteroaryl group, a polycyclic heteroaryl group, or both a monocyclic heteroaryl group and a polycyclic heteroaryl group. For example, the heteroaryl group in the heteroarylamine group may be selected from the above-described examples of the heteroaryl group.

In the present specification, examples of the heteroaryl group in the N-arylheteroarylamine group and the N-alkylheteroarylamine group are the same as the above-described examples of the heteroaryl group.

In the present specification, an aromatic ring group may be monocyclic or polycyclic, and may be selected from the examples of the aryl group.

In the present specification, the above-described description on the aryl group may be applied to an aryl group in an aryloxy group, an arylthioxy group, an arylsulfoxy group, an arylphosphine group, an aralkyl group, an aralkylamine group, an aralkenyl group, an alkylaryl group, an arylamine group, and an arylheteroarylamine group.

In the present specification, the above-described description on the alkyl group may be applied to an alkyl group in an alkylthioxy group, an alkylsulfoxy group, an aralkyl group, an aralkylamine group, an alkylaryl group, and an alkylamine group.

In the present specification, the above-described description on the heterocyclic group may be applied to a heteroaryl group in a heteroaryl group, a heteroarylamine group, and an arylheteroarylamine group, except for an aromatic ring.

In the present specification, the above-described description on the aryl group may be applied to an arylene group except for a divalent arylene group.

In the present specification, an alkylene group means a group having two bonding positions in an alkyl group, that is, a divalent group. The above-described description on the alkyl group may be applied to the alkylene group, except for a divalent group.

In the present specification, the cycloalkylene group means a group having two bonding positions in a cycloalkyl group, that is, a divalent group. The above-described description on the cycloalkyl group may be applied to the cycloalkylene groups, except for a divalent group.

In the present specification, the above-described description on the heterocyclic group may be applied to a divalent heterocyclic group except for a divalent group.

The compound of the present invention is represented by any one of the following Formulae 1-11 to 1-13 and 1-15. 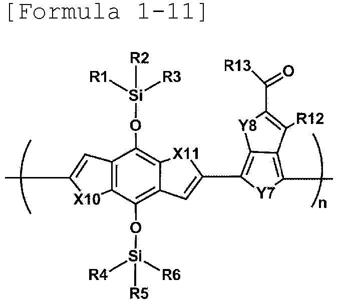 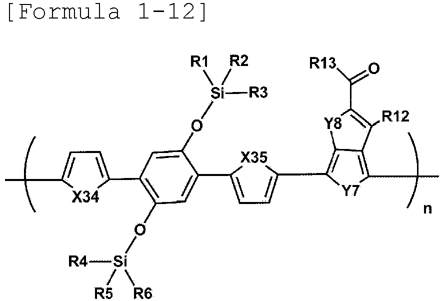 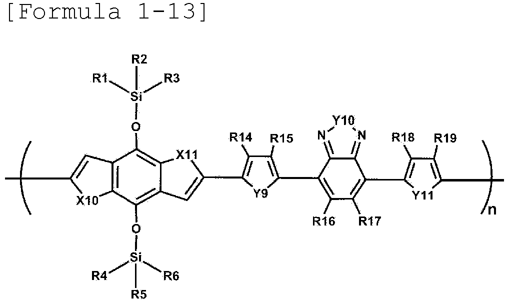 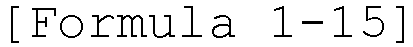 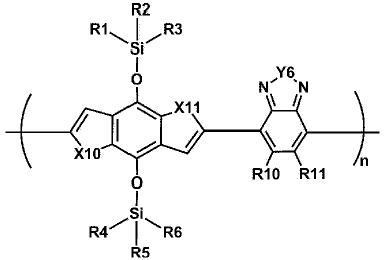 In the above Formulae,
R1 to R6 are the same as or different from each other, and are each independently an alkyl group,
X10, X11, X34, X35, and Y6 to Y11 are the same as or different from each other, and are each independently S, O, Se, Te, NR, CRR', SiRR', PR', or GeRR', and
R10 to R19, R, and R' are the same as or different from each other, and are each independently hydrogen; deuterium; a halogen group; a nitrile group; a nitro group; a hydroxyl group; a carbonyl group; an ester group; an imide group; an amide group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; or a substituted or unsubstituted heterocyclic group.

In an exemplary embodiment of the present specification, X10, X11, X34, and X35 are the same as or different from each other, and are each independently S, O, or NR, and R is the same as that described above.

In an exemplary embodiment of the present specification, X10, X11, X34, and X35 are S.

In an exemplary embodiment of the present specification, R1 to R6 are the same as or different from each other, and are each independently an alkyl group having 1 to 30 carbon atoms.

In an exemplary embodiment of the present specification, R1 to R6 are the same as or different from each other, and are each independently an alkyl group having 1 to 20 carbon atoms.

In an exemplary embodiment of the present specification, R1 to R6 are the same as or different from each other, and are each independently an alkyl group having 4 to 20 carbon atoms.

In an exemplary embodiment of the present specification, Y6 to Y11 are the same as or different from each other, and are each independently S, O or NR, and R is the same as that described above.

In an exemplary embodiment of the present specification, Y6 to Y11 are S.

In an exemplary embodiment of the present specification, R13 is a substituted or unsubstituted alkyl group.

In an exemplary embodiment of the present specification, R13 is a straight-chained or branched alkyl group.

In an exemplary embodiment of the present specification, R13 is a straight-chained or branched alkyl group having 1 to 30 carbon atoms.

In an exemplary embodiment of the present specification, R13 is a straight-chained or branched alkyl group having 1 to 20 carbon atoms.

In an exemplary embodiment of the present specification, R12 is a halogen group.

In an exemplary embodiment of the present specification, R12 is fluorine.

In an exemplary embodiment of the present specification, R10, R11, and R14 to R19 are the same as or different from each other, and are each independently hydrogen; a halogen group; a substituted or unsubstituted alkoxy group; a substituted or unsubstituted alkyl group; a substituted or unsubstituted aryl group; or a substituted or unsubstituted heterocyclic group.

In an exemplary embodiment of the present specification, R10, R11, and R14 to R19 are the same as or different from each other, and are each independently hydrogen; a halogen group; or a substituted or unsubstituted alkoxy group.

In an exemplary embodiment of the present specification, R14, R15, R18, and R19 are hydrogen.

In an exemplary embodiment of the present specification, R10, R11, R16, and R17 are the same as or different from each other, and are each independently a halogen group; or a substituted or unsubstituted alkoxy group.

In an exemplary embodiment of the present specification, R10, R11, R16, and R17 are the same as or different from each other, and are each independently a halogen group; or an alkoxy group unsubstituted or substituted with an alkyl group.

In an exemplary embodiment of the present specification, R10, R11, R16, and R17 are the same as or different from each other, and are each independently fluorine; or an alkoxy group substituted with an alkyl group having 1 to 30 carbon atoms.

In an exemplary embodiment of the present specification, R10, R11, R16, and R17 are the same as or different from each other, and are each independently fluorine; or an alkoxy group substituted with an alkyl group having 1 to 20 carbon atoms.

In an exemplary embodiment of the present specification, an end group of the compound is thiophene.

An exemplary embodiment of the present specification provides an organic solar cell including: a first electrode;
a second electrode provided to face the first electrode; and
an organic material layer having one or more layers provided between the first electrode and the second electrode and including a photoactive layer,
in which one or more layers of the organic material layer include the compound.

In an exemplary embodiment of the present specification, the organic solar cell may further include an additional organic material layer. The organic solar cell may reduce the number of organic material layers by using an organic material which simultaneously has various functions.

In an exemplary embodiment of the present specification, the organic solar cell includes a first electrode, a photoactive layer, and a second electrode. The organic solar cell may further include a substrate, a hole transport layer, and/or an electron transport layer.

In an exemplary embodiment of the present specification, the photoactive layer includes the compound.

In an exemplary embodiment of the present specification, the organic material layer includes a hole transport layer, a hole injection layer, or a layer which simultaneously transports and injects holes, and the hole transport layer, the hole injection layer, or the layer which simultaneously transports and injects holes includes the compound.

In another exemplary embodiment, the organic material layer includes an electron injection layer, an electron transport layer, or a layer which simultaneously injects and transports electrons, and the electron injection layer, the electron transport layer, or the layer which simultaneously injects and transports electrons includes the compound.

In an exemplary embodiment of the present specification, the organic solar cell further includes one or two or more organic material layers selected from the group consisting of a hole injection layer, a hole transport layer, a hole blocking layer, a charge generation layer, an electron blocking layer, an electron injection layer, and an electron transport layer.

In an exemplary embodiment of the present specification, in the organic solar cell, a cathode, a photoactive layer, and an anode may be arranged in this order, and an anode, a photoactive layer, and a cathode may be arranged in this order, but the arrangement order is not limited thereto.

In another exemplary embodiment, in the organic solar cell, an anode, a hole transport layer, a photoactive layer, an electron transport layer, and a cathode may also be arranged in this order, and a cathode, an electron transport layer, a photoactive layer, a hole transport layer, and an anode may also be arranged in this order, but the arrangement order is not limited thereto.

In an exemplary embodiment of the present specification, the photoactive layer includes an electron donor and an electron acceptor, and the electron donor includes the compound.

In an exemplary embodiment of the present specification, a material for the electron acceptor may be selected from the group consisting of fullerene, fullerene derivatives, bathocuproine, semi-conducting elements, semi-conducting compounds, and combinations thereof. Specifically, the material for the electron acceptor may be phenyl C₆₀-butyric acid methyl ester (PC₆₀BM), phenyl C₆₁-butyric acid methyl ester (PC₆₁BM), or phenyl C₇₁-butyric acid methyl ester (PC₇₁BM).

In an exemplary embodiment of the present specification, the electron donor and the electron acceptor constitute a bulk heterojunction (BHJ). A material for the electron donor and a material for the electron acceptor may be mixed at a ratio (w/w) of 1:10 to 10:1. Specifically, the material for the electron donor and the material for the electron acceptor may be mixed at a ratio (w/w) of 1:1 to 1:10, and more specifically, the material for the electron donor and the material for the electron acceptor may be mixed at a ratio (w/w) of 1:1 to 1:5. If necessary, the material for the electron donor and the material for the electron acceptor may be mixed at a ratio (w/w) of 1:1 to 1:3.

In an exemplary embodiment of the present specification, the photoactive layer has a bilayer thin film structure including an n-type organic material layer and a p-type organic material layer, and the p-type organic material layer includes the compound.

In the present specification, the substrate may be a glass substrate or a transparent plastic substrate having excellent transparency, surface smoothness, ease of handling, and waterproofing properties, but is not limited thereto, and the substrate is not limited as long as the substrate is typically used in the organic solar cell. Specific examples thereof include glass or polyethylene terephthalate (PET), polyethylene naphthalate (PEN), polypropylene (PP), polyimide (PI), triacetyl cellulose (TAC), and the like, but are not limited thereto.

The first electrode may be a material which is transparent and has excellent conductivity, but is not limited thereto. Examples thereof include: a metal such as vanadium, chromium, copper, zinc, and gold, or an alloy thereof; a metal oxide such as zinc oxide, indium oxide, indium tin oxide (ITO), and indium zinc oxide (IZO); a combination of a metal and an oxide, such as ZnO:Al or SnO₂:Sb; a conductive polymer, such as poly(3-methylthiophene), poly[3,4-(ethylene-1,2-dioxythiophene] (PEDOT), polypyrrole, and polyaniline; and the like, but are not limited thereto.

A method of forming the first electrode is not particularly limited, but the first electrode may be formed, for example, by being applied onto one surface of a substrate using a method such as sputtering, e-beam, thermal deposition, spin coating, screen printing, inkjet printing, doctor blade, or gravure printing, or by being coated in the form of a film.

When the first electrode is formed on a substrate, the first electrode may be subjected to processes of cleaning, removing moisture, and hydrophilic modification.

For example, a patterned ITO substrate is sequentially cleaned with a cleaning agent, acetone, and isopropyl alcohol (IPA), and then dried on a hot plate at 100°C to 150°C for 1 to 30 minutes, preferably at 120°C for 10 minutes in order to remove moisture, and when the substrate is completely cleaned, the surface of the substrate is hydrophilically modified.

Through the surface modification as described above, the junction surface potential may be maintained at a level suitable for a surface potential of a photoactive layer. Further, during the modification, a polymer thin film may be easily formed on the first electrode, and the quality of the thin film may also be improved.

Examples of a pre-treatment technology for the first electrode include a) a surface oxidation method using a parallel flat plate-type discharge, b) a method of oxidizing the surface through ozone produced by using UV rays in a vacuum state, c) an oxidation method using oxygen radicals produced by plasma, and the like.

One of the methods may be selected according to the state of the first electrode or the substrate. However, although any method is used, it is preferred to commonly prevent oxygen from being separated from the surface of the first electrode or the substrate, and maximally inhibit moisture and organic materials from remaining. In this case, it is possible to maximize a substantial effect of the pre-treatment.

As a specific example, it is possible to use a method of oxidizing the surface through ozone produced by using UV. In this case, a patterned ITO substrate after being ultrasonically cleaned is baked on a hot plate and dried well, and then introduced into a chamber, and the patterned ITO substrate may be cleaned by ozone generated by allowing an oxygen gas to react with UV light by operating a UV lamp.

However, the surface modification method of the patterned ITO substrate in the present specification need not be particularly limited, and any method may be used as long as the method is a method of oxidizing a substrate.

The second electrode may be a metal having a low work function, but is not limited thereto. Specific examples thereof include: a metal such as magnesium, calcium, sodium, potassium, titanium, indium, yttrium, lithium, gadolinium, aluminum, silver, tin, and lead, or an alloy thereof; and a multi-layer structured material, such as LiF/Al, LiO₂/Al, LiF/Fe, Al:Li, Al:BaF₂, and Al:BaF₂:Ba, but are not limited thereto.

The second electrode may be deposited and formed in a thermal evaporator showing a vacuum degree of 5 x 10⁻⁷ torr or less, but the forming method is not limited to this method.

A material for the hole transport layer and/or a material for the electron transport layer serve to efficiently transfer electrons and holes separated from a photoactive layer to an electrode, and the materials are not particularly limited.

The material for the hole transport layer may be poly(3,4-ethylenedioxythiophene) doped with poly(styrenesulfonic acid) (PEDOT:PSS) and molybdenum oxide (MoOₓ); vanadium oxide (V₂O₅); nickel oxide (NiO); tungsten oxide (WOₓ); and the like, but is not limited thereto.

The material for the electron transport layer may be electron-extracting metal oxides, and specific examples thereof include: metal complexes of 8-hydroxyquinoline; complexes including Alq₃; metal complexes including Liq; LiF; Ca; titanium oxide (TiOₓ); zinc oxide (ZnO); cesium carbonate (Cs₂CO₃); and the like, but are not limited thereto.

The photoactive layer may be formed by dissolving a photoactive material such as an electron donor and/or an electron acceptor in an organic solvent, and then applying the solution by a method such as spin coating, dip coating, screen printing, spray coating, doctor blade, and brush painting, but the forming method is not limited thereto.

A preparation method of the compound and the manufacture of an organic solar cell including the same will be described in detail in the following Preparation Examples and Examples. However, the following Examples are provided for exemplifying the present specification, and the scope of the present specification is not limited thereby.

### Preparation Example 1. Preparation of Compound A-1

### (1) Preparation of Compound 1-b

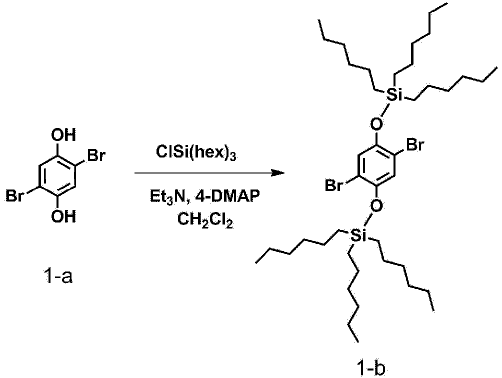

Compound 1-a (2 g, 7.47 mmol) and 4-dimethylaminopyridine (4-DMAP) (0.36 g, 2.92 mmol) were dissolved in 30 mL of dichloromethane, and then triethylamine (Et₃N) (3 mL, 21.51 mmol) and trihexylchlorosilane (ClSi(hex)₃) (7.46 mL, 20.37 mmol) were added thereto at 0°C, and the resulting mixture was stirred at room temperature for 12 hours. After the reaction, a reactant was added to 100 mL of water, an extraction was performed with dichloromethane (CH₂Cl₂), the remaining water was removed over magnesium sulfate (MgSO₄), and then the solvent was removed under reduced pressure. The remaining product was purified with silica column (eluent: hexane) to obtain Compound 1-b (yield; 94%).

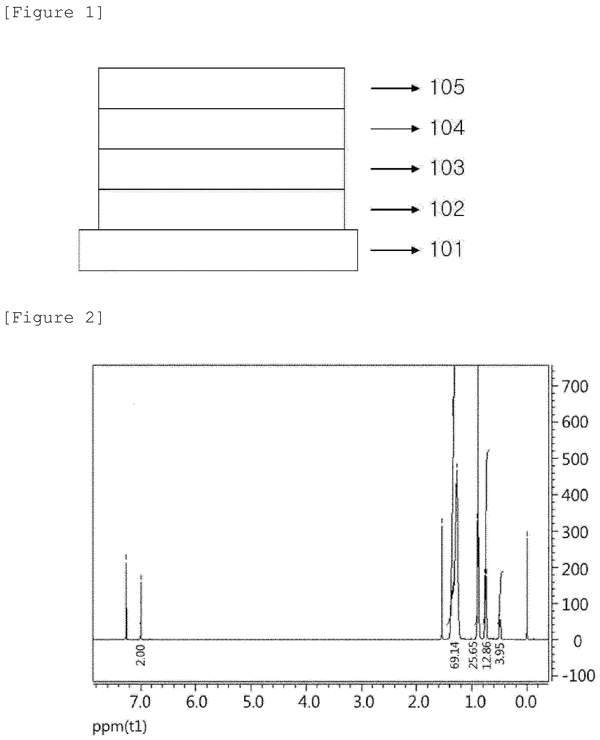

FIG. 2 is a view illustrating an NMR spectrum of Compound 1-b.

### (2) Preparation of Compound 1-c

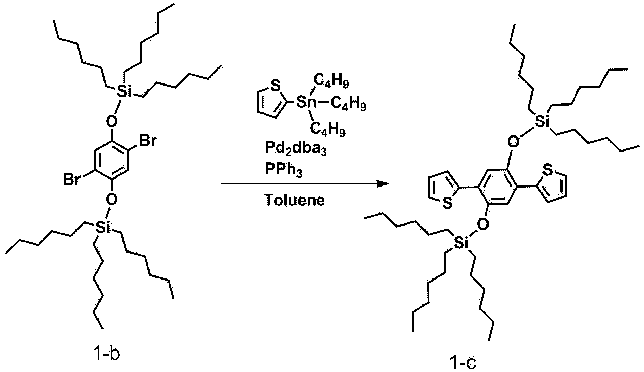

Compound 1-b (5 g, 6 mmol) and tributyltin-thiophene (9.33 g, 25 mmol) were dissolved in 70 mL of toluene and a tris(dibenzylideneacetone)dipalladium(0) (Pd₂dba₃) catalyst (0.458 g, 0.05 mmol) and a triphenylphosphine (PPh₃) ligand (0.52 g, 2 mmol) were added thereto, and the resulting mixture was stirred at 110°C for 48 hours. After the reaction, an extraction was performed with dichloromethane, the remaining water was removed over magnesium sulfate (MgSO₄), and then the solvent was removed under reduced pressure. The remaining product was purified with silica column (eluent: hexane) to obtain Compound 1-c (yield; 59%).

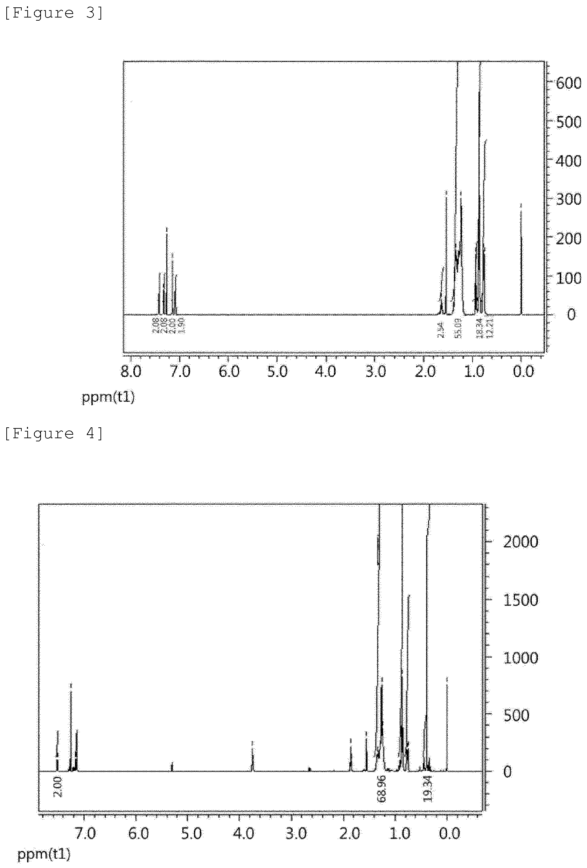

FIG. 3 is a view illustrating an NMR spectrum of Compound 1-c.

### (3) Preparation of Compound A-1

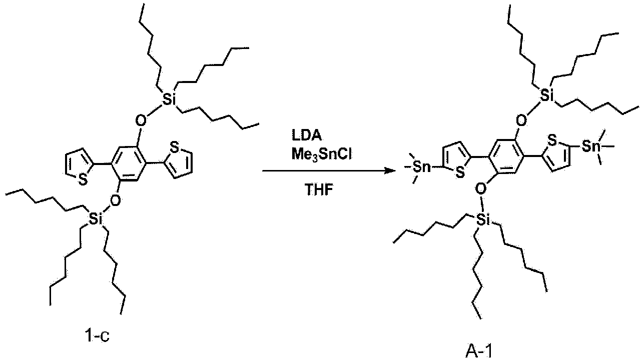

After Compound 1-c (2.7 g, 3.18 mmol) was dissolved in 40 mL of tetrahydrofuran (THF) and, 2 M lithium diisopropylamide (LDA) (8.75 mL, 17.5 mmol) was slowly injected thereinto at -78°C, and then the resulting mixture was stirred at -78°C for 2 hours. Trimethyltin chloride (Me₃SnCl) (18 mL, 18 mmol) was added thereto at the same temperature, and the resulting mixture was slowly warmed to room temperature, and then was allowed to react at room temperature for 3 hours. After the reaction, an extraction was performed with dichloromethane, the remaining water was removed over magnesium sulfate (MgSO₄), and then the solvent was removed under reduced pressure, thereby obtaining Compound A-1 (yield 78%).

FIG. 4 is a view illustrating an NMR spectrum of Compound A-1.

### Preparation Example 2. Preparation of Compound A-2

### (1) Preparation of Compound 1-e

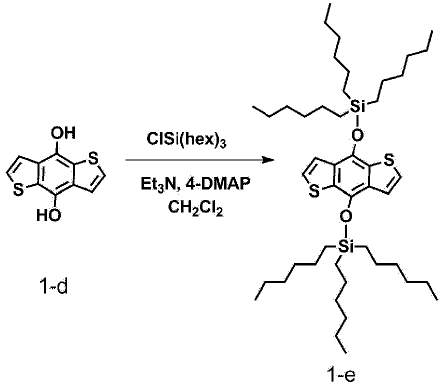

Compound 1-d (1.6 g, 7.47 mmol) and 4-dimethylaminopyridine (4-DMAP) (0.35 g, 2.92 mmol) were dissolved in a solution in which 30 mL of dichloromethane and 5 mL of dimethylformamide-OH (DMF-OH) are mixed, and then triethylamine (Et₃N) (10.2 mmol) and trihexylchlorosilane (ClSi(hex)₃) (7.46 mL, 20.4 mmol) were added thereto at 0°C, and the resulting mixture was stirred at room temperature for 12 hours. After the reaction, a reactant was added to 100 mL of water, an extraction was performed with dichloromethane (CH₂Cl₂), and the remaining product was purified through column chromatography, thereby obtaining Compound 1-e (yield: 19%).

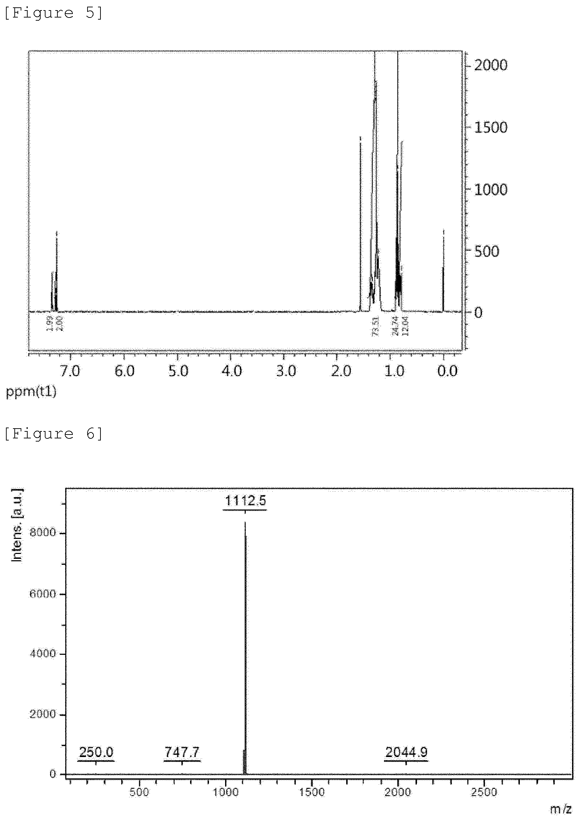

FIG. 5 is a view illustrating an NMR spectrum of Compound 1-e.

### (2) Preparation of Compound A-2

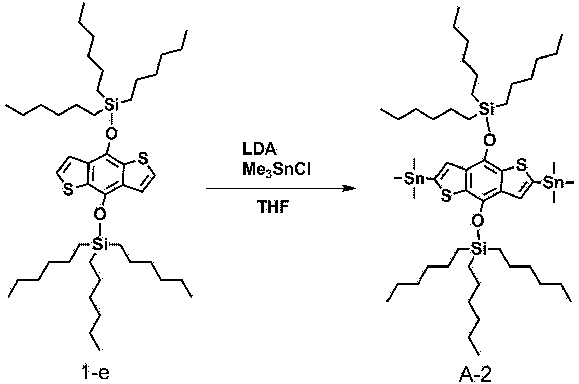

After Compound 1-e (1 g, 1.41 mmol) was dissolved in 30 mL of tetrahydrofuran (THF), 2 M lithium diisopropylamide (LDA) (3.9 mL, 7.8 mmol) was slowly injected thereinto at -78°C, and then the resulting mixture was stirred at -78°C for 2 hours. Trimethyltin chloride (Me₃SnCl) (8.55 mL, 8.5 mmol) was added thereto at the same temperature, and the resulting mixture was slowly warmed to room temperature, and then stirred at room temperature overnight. After the reaction, an extraction was performed with dichloromethane, the remaining water was removed over magnesium sulfate (MgSO₄), and then the solvent was removed under reduced pressure, thereby obtaining Compound A-2 (yield 76%).

FIG. 6 is a view illustrating an MS spectrum of Compound A-2.

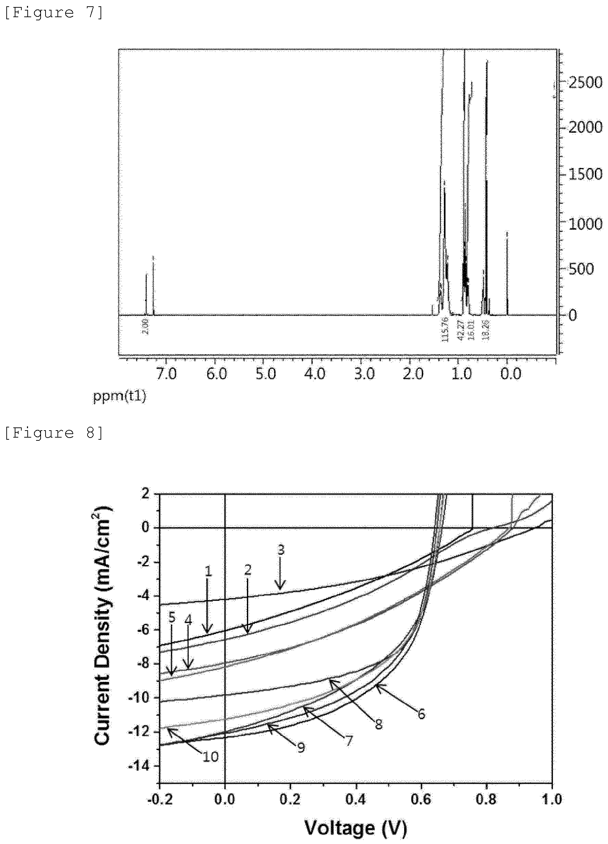

FIG. 7 is a view illustrating an NMR spectrum of Compound A-2.

### Preparation Example 3. Preparation of Compound 1

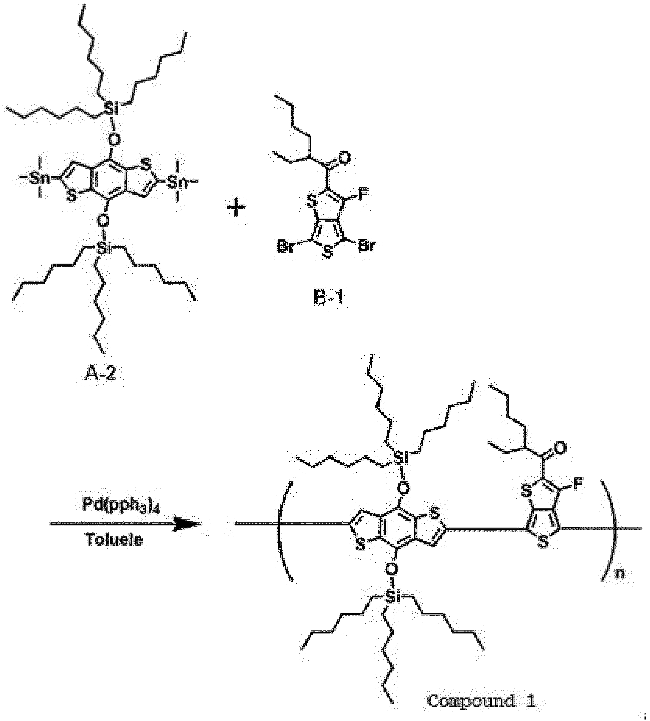

5 mL of toluene, Compound A-2 (0.3 mmol), Compound B-1 (0.3 mmol), and a
tetrakis(triphenylphosphine)palladium(0) catalyst (Pd(PPh₃)₄) (0.06 mmol) were put into a 10-mL microwave tube, the microwave tube was sealed, and then the gas was removed therefrom for 10 minutes. Thereafter, the mixture was put into a reactor, and was allowed to react at each of 110°C, 130°C, and 140°C for 10 minutes, and at 150°C for 1 hour by gradually heating the mixture. Thereafter, 0.5 mL of Br-benzotrifluoride was added thereto, and the resulting mixture was stirred at 150°C for 1 hour, and then cooled to room temperature. After the mixture was poured into 50 mL of methanol, the solid was filtered, the resulting mixture was subjected to soxhlet extraction in methanol, acetone, hexane, and chloroform, and then the solid was filtered by precipitating the extract in methanol again. Thereafter, the resulting material was dried under a vacuum condition to obtain 0.14 g of Compound 1 (yield: 43.5%).

### Preparation Example 4. Preparation of Compound 2

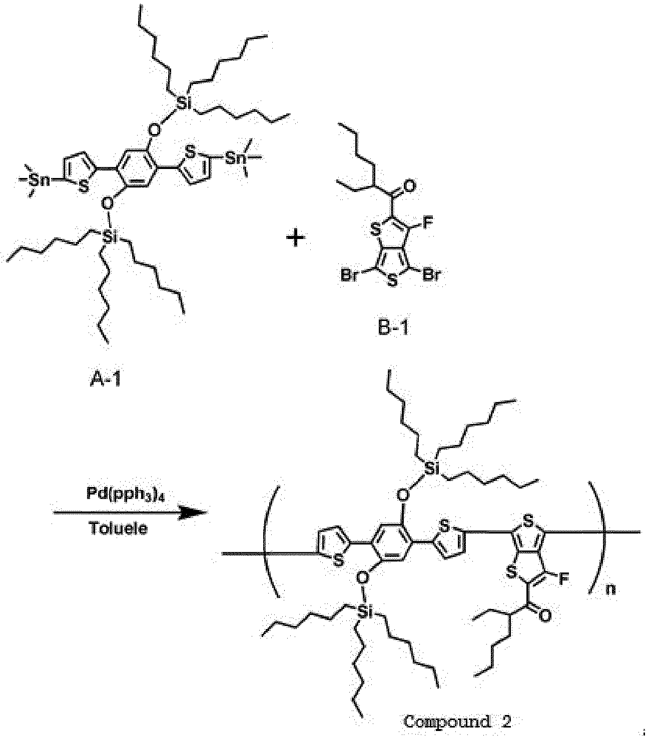

5 mL of toluene, Compound A-1 (0.3 mmol), Compound B-1 (0.3 mmol), and a
tetrakis(triphenylphosphine)palladium(0) catalyst (Pd(PPh₃)₄) (0.06 mmol) were put into a 10-mL microwave tube, the microwave tube was sealed, and then the gas was removed therefrom for 10 minutes. Thereafter, the mixture was put into a reactor, and was allowed to react at each of 110°C, 130°C, and 140°C for 10 minutes, and at 150°C for 1 hour by gradually heating the mixture. Thereafter, 0.5 mL of Br-benzotrifluoride was added thereto, and the resulting mixture was stirred at 150°C for 1 hour, and then cooled to room temperature. After the mixture was poured into 50 mL of methanol, the solid was filtered, the resulting mixture was subjected to soxhlet extraction in methanol, acetone, hexane, and chloroform, and then the solid was filtered by precipitating the extract in methanol again. Thereafter, the resulting material was dried under a vacuum condition to obtain 0.21 g of Compound 2 (yield: 62.3%).

### Preparation Example 5. Preparation of Compound 3

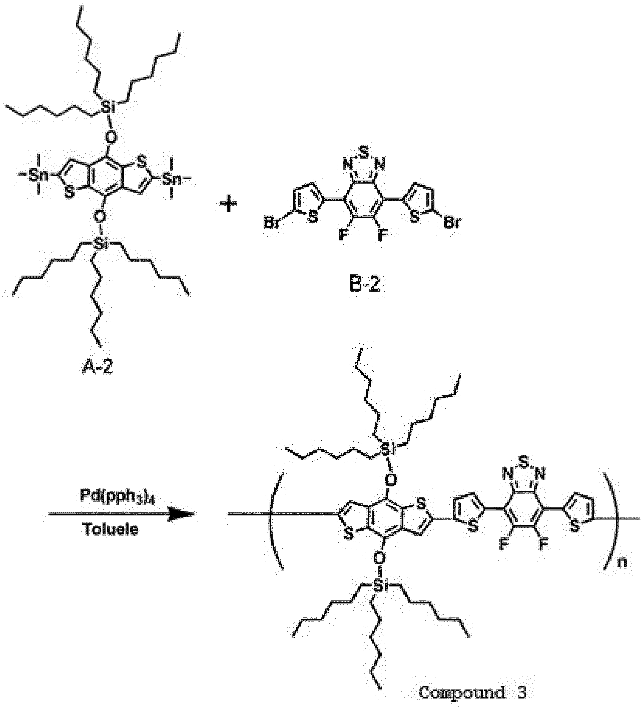

5 mL of toluene, Compound A-2 (0.3 mmol), Compound B-2 (0.3 mmol), and a
tetrakis(triphenylphosphine)palladium(0) catalyst (Pd(PPh₃)₄) (0.06 mmol) were put into a 10-mL microwave tube, the microwave tube was sealed, and then the gas was removed therefrom for 10 minutes. Thereafter, the mixture was put into a reactor, and was allowed to react at each of 110°C, 130°C, and 140°C for 10 minutes, and at 150°C for 1 hour by gradually heating the mixture. Thereafter, 0.5 mL of Br-benzotrifluoride was added thereto, and the resulting mixture was stirred at 150°C for 1 hour, and then cooled to room temperature. After the mixture was poured into 50 mL of methanol, the solid was filtered, the resulting mixture was subjected to soxhlet extraction in methanol, acetone, hexane, and chloroform, and then the solid was filtered by precipitating the extract in methanol again. Thereafter, the resulting material was dried under a vacuum condition to obtain 0.25 g of Compound 3 (yield: 75.1%).

### Preparation Example 6. Preparation of Compound 4(not in accordance with the present invention).

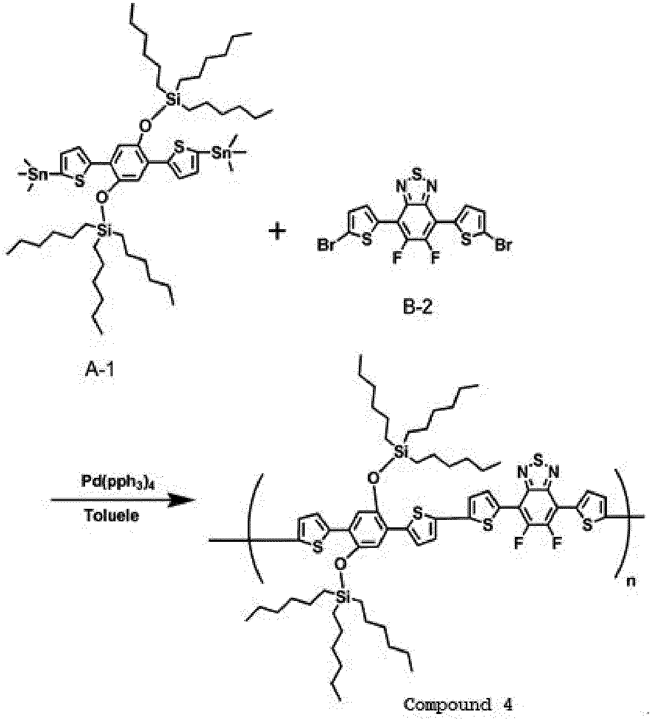

5 mL of toluene, Compound A-1 (0.3 mmol), Compound B-2 (0.3 mmol), and a
tetrakis(triphenylphosphine)palladium(0) catalyst (Pd(PPh₃)₄) (0.06 mmol) were put into a 10-mL microwave tube, the microwave tube was sealed, and then the gas was removed therefrom for 10 minutes. Thereafter, the mixture was put into a reactor, and was allowed to react at each of 110°C, 130°C, and 140°C for 10 minutes, and at 150°C for 1 hour by gradually heating the mixture. Thereafter, 0.5 mL of Br-benzotrifluoride was added thereto, and the resulting mixture was stirred at 150°C for 1 hour, and then cooled to room temperature. After the mixture was poured into 50 mL of methanol, the solid was filtered, the resulting mixture was subjected to soxhlet extraction in methanol, acetone, hexane, and chloroform, and then the solid was filtered by precipitating the extract in methanol again. Thereafter, the resulting material was dried under a vacuum condition to obtain 0.19 g of Compound 4 (yield: 53.8%).

### Preparation Example 7. Preparation of Compound 5

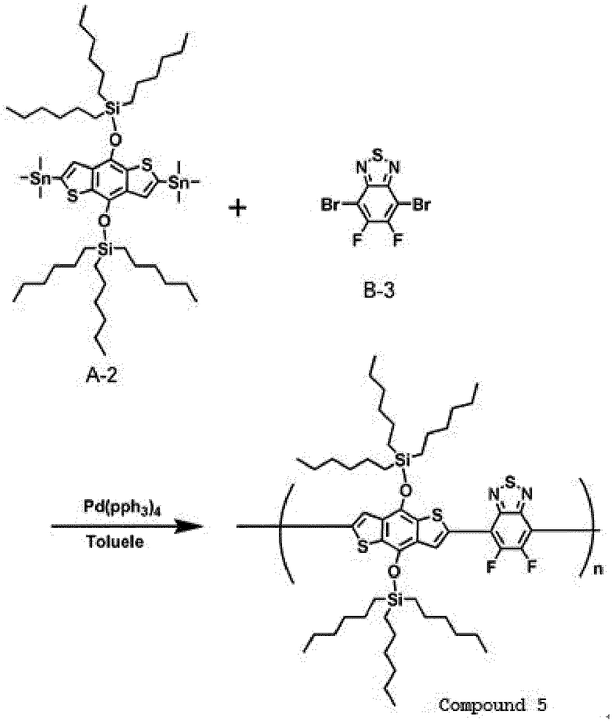

5 mL of toluene, Compound A-2 (0.3 mmol), Compound B-3 (0.3 mmol), and a
tetrakis(triphenylphosphine)palladium(0) catalyst (Pd(PPh₃)₄) (0.06 mmol) were put into a 10-mL microwave tube, the microwave tube was sealed, and then the gas was removed therefrom for 10 minutes. Thereafter, the mixture was put into a reactor, and was allowed to react at each of 110°C, 130°C, and 140°C for 10 minutes, and at 150°C for 1 hour by gradually heating the mixture. Thereafter, 0.5 mL of Br-benzotrifluoride was added thereto, and the resulting mixture was stirred at 150°C for 1 hour, and then cooled to room temperature. After the mixture was poured into 50 mL of methanol, the solid was filtered, the resulting mixture was subjected to soxhlet extraction in methanol, acetone, hexane, and chloroform, and then the solid was filtered by precipitating the extract in methanol again. Thereafter, the resulting material was dried under a vacuum condition to obtain 0.156 g of Compound 5 (yield: 55%).

### Preparation Example 8. Preparation of Compound 6 (not in accordance with the present invention).

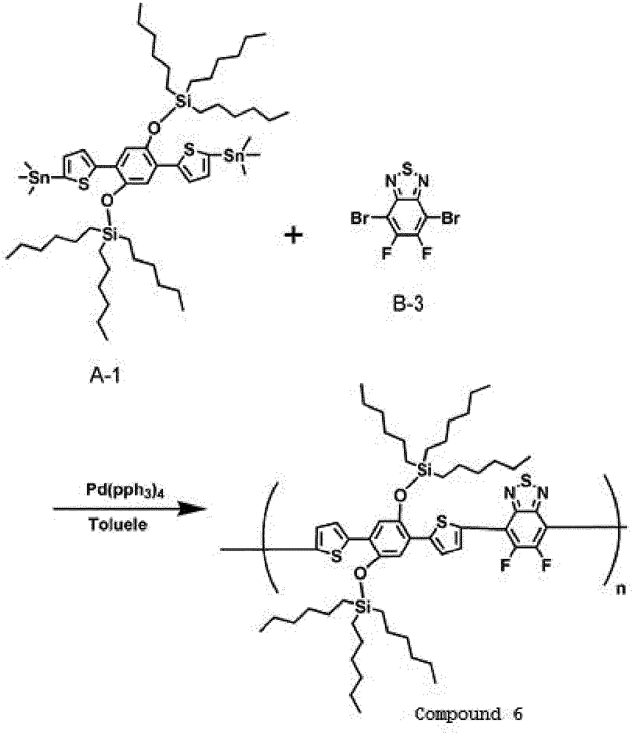

5 mL of toluene, Compound A-1 (0.3 mmol), Compound B-3 (0.3 mmol), and a
tetrakis(triphenylphosphine)palladium(0) catalyst (Pd(PPh₃)₄) (0.06 mmol) were put into a 10-mL microwave tube, the microwave tube was sealed, and then the gas was removed therefrom for 10 minutes. Thereafter, the mixture was put into a reactor, and was allowed to react at each of 110°C, 130°C, and 140°C for 10 minutes, and at 150°C for 1 hour by gradually heating the mixture. Thereafter, 0.5 mL of Br-benzotrifluoride was added thereto, and the resulting mixture was stirred at 150°C for 1 hour, and then cooled to room temperature. After the mixture was poured into 50 mL of methanol, the solid was filtered, the resulting mixture was subjected to soxhlet extraction in methanol, acetone, hexane, and chloroform, and then the solid was filtered by precipitating the extract in methanol again. Thereafter, the resulting material was dried under a vacuum condition to obtain 0.17 g of Compound 6 (yield: 56%).

### Preparation Example 9. Preparation of Compound 7

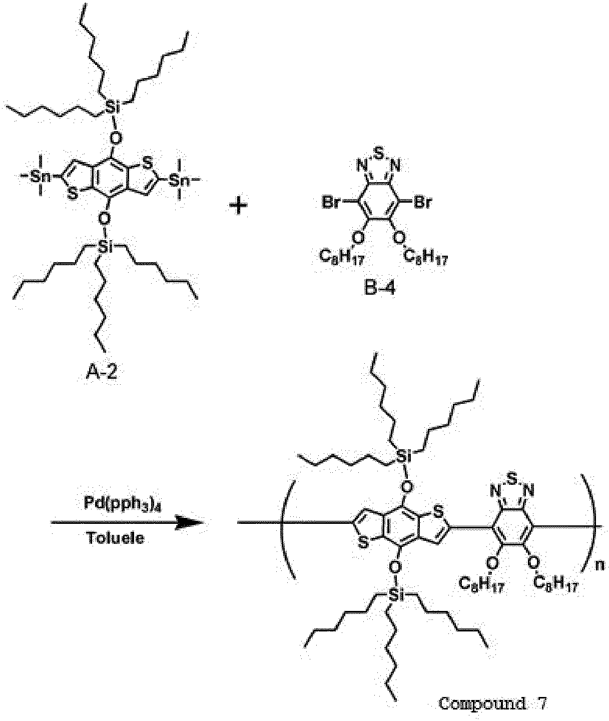

5 mL of toluene, Compound A-2 (0.3 mmol), Compound B-4 (0.3 mmol), and a
tetrakis(triphenylphosphine)palladium(0) catalyst (Pd(PPh₃)₄) (0.06 mmol) were added to a 10-mL microwave tube, the microwave tube was sealed, and then the gas was removed therefrom for 10 minutes. Thereafter, the mixture was put into a reactor, and was allowed to react at each of 110°C, 130°C, and 140°C for 10 minutes, and at 150°C for 1 hour by gradually heating the mixture. Thereafter, 0.5 mL of Br-benzotrifluoride was added thereto, and the resulting mixture was stirred at 150°C for 1 hour, and then cooled to room temperature. After the mixture was poured into 50 mL of methanol, the solid was filtered, the resulting mixture was subjected to soxhlet extraction in methanol, acetone, hexane, and chloroform, and then the solid was filtered by precipitating the extract in methanol again. Thereafter, the resulting material was dried under a vacuum condition to obtain 0.22 g of Compound 7 (yield: 63%).

### Preparation Example 10. Preparation of Compound 8 (not in accordance with the present invention).

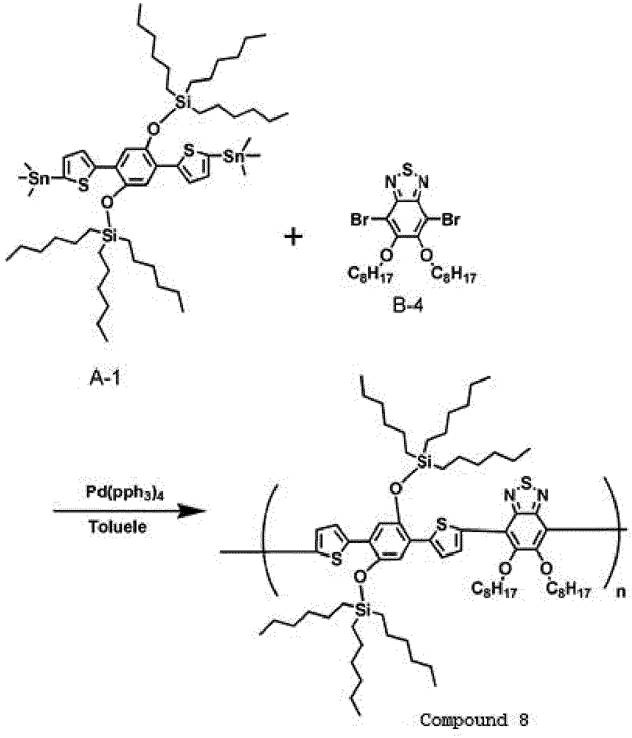

5 mL of toluene, Compound A-1 (0.3 mmol), Compound B-4 (0.3 mmol), and a
tetrakis(triphenylphosphine)palladium(0) catalyst (Pd(PPh₃)₄) (0.06 mmol) were added to a 10-mL microwave tube, the microwave tube was sealed, and then the gas was removed therefrom for 10 minutes. Thereafter, the mixture was put into a reactor, and was allowed to react at each of 110°C, 130°C, and 140°C for 10 minutes, and at 150°C for 1 hour by gradually heating the mixture. Thereafter, 0.5 mL of Br-benzotrifluoride was added thereto, and the resulting mixture was stirred at 150°C for 1 hour, and then cooled to room temperature. After the mixture was poured into 50 mL of methanol, the solid was filtered, the resulting mixture was subjected to soxhlet extraction in methanol, acetone, hexane, and chloroform, and then the solid was filtered by precipitating the extract in methanol again. Thereafter, the resulting material was dried under a vacuum condition to obtain 0.23 g of Compound 8 (yield: 62%).

### Preparation Example 11. Preparation of Compound 9

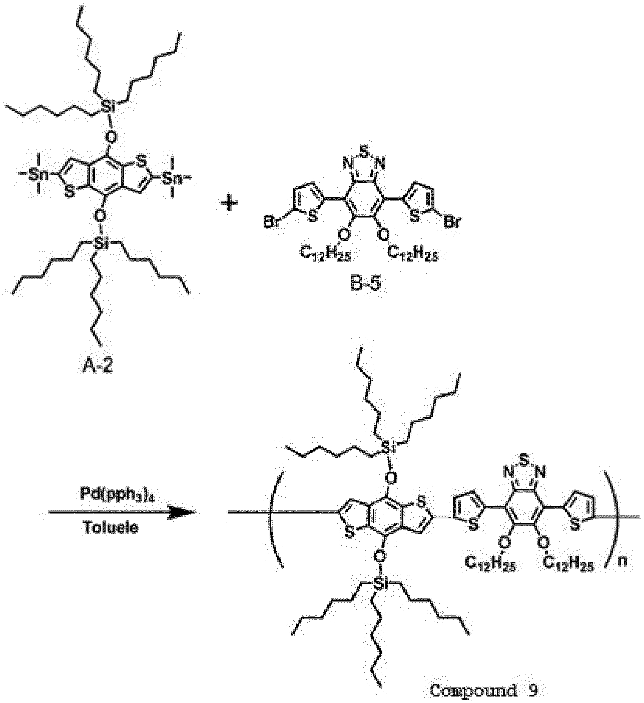

5 mL of toluene, Compound A-2 (0.3 mmol), Compound B-5 (0.3 mmol), and a
tetrakis(triphenylphosphine)palladium(0) catalyst (Pd(PPh₃)₄) (0.06 mmol) were added to a 10-mL microwave tube, the microwave tube was sealed, and then the gas was removed therefrom for 10 minutes. Thereafter, the mixture was put into a reactor, and was allowed to react at each of 110°C, 130°C, and 140°C for 10 minutes, and at 150°C for 1 hour by gradually heating the mixture. Thereafter, 0.5 mL of Br-benzotrifluoride was added thereto, and the resulting mixture was stirred at 150°C for 1 hour, and then cooled to room temperature. After the mixture was poured into 50 mL of methanol, the solid was filtered, the resulting mixture was subjected to soxhlet extraction in methanol, acetone, hexane, and chloroform, and then the solid was filtered by precipitating the extract in methanol again. Thereafter, the resulting material was dried under a vacuum condition to obtain 0.35 g of Compound 9 (yield: 81%).

### Preparation Example 12. Preparation of Compound 10 (not in accordance with the present invention).

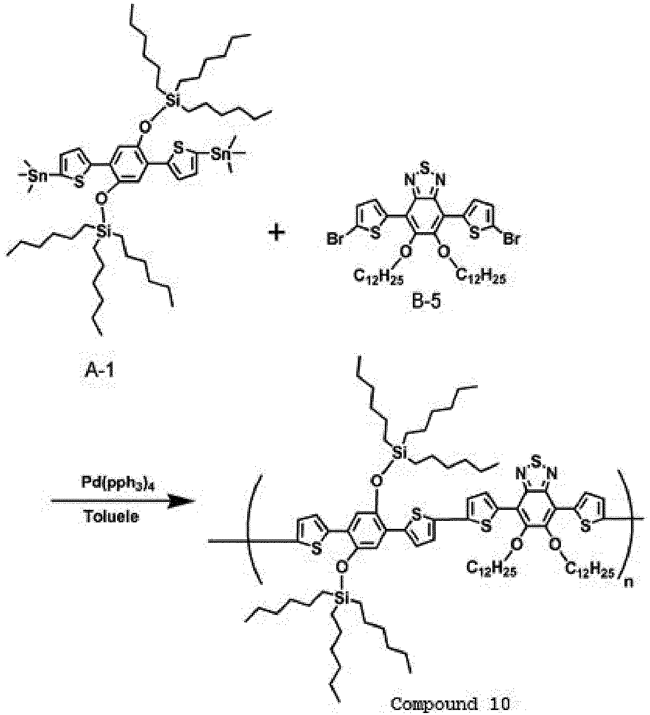

5 mL of toluene, Compound A-1 (0.3 mmol), Compound B-5 (0.3 mmol), and a
tetrakis(triphenylphosphine)palladium(0) catalyst (Pd(PPh₃)₄) (0.06 mmol) were put into a 10-mL microwave tube, the microwave tube was sealed, and then the gas was removed therefrom for 10 minutes. Thereafter, the mixture was put into a reactor, and was allowed to react at each of 110°C, 130°C, and 140°C for 10 minutes, and at 150°C for 1 hour by gradually heating the mixture. Thereafter, 0.5 mL of Br-benzotrifluoride was added thereto, and the resulting mixture was stirred at 150°C for 1 hour, and then cooled to room temperature. After the mixture was poured into 50 mL of methanol, the solid was filtered, the resulting mixture was subjected to soxhlet extraction in methanol, acetone, hexane, and chloroform, and then the solid was filtered by precipitating the extract in methanol again. Thereafter, the resulting material was dried under a vacuum condition to obtain 0.28 g of Compound 10 (yield: 61.8%)

### Example 1. Manufacture of Organic Solar Cell

A composite solution was prepared by dissolving Compound 1 prepared in the Preparation Example as a donor and PCBM as an acceptor at a ratio of 1:2 in chlorobenzene (CB). In this case, the concentration thereof was adjusted to 2.0 wt%, and the organic solar cell was made to have a structure of ITO/ZnO/a photoactive layer/MoO_{3/}Ag. A glass substrate coated with ITO was ultrasonically washed using distilled water, acetone, and 2-propanol, and the ITO surface was treated with ozone for 10 minutes, followed by a heat treatment at 120°C for 10 minutes by spin-coating a ZnO precursor solution. Thereafter, the composite solution was filtered with a 0.45 µm PP syringe filter, and then spin-coated to form a photoactive layer. Thereafter, MoO₃ was deposited onto the photoactive layer to a thickness of 5 nm to 20 nm at a rate of 0.4 Å/s in a thermal evaporator, thereby preparing a hole transport layer. Thereafter, Ag was deposited onto the hole transport layer to a thickness of 10 nm at a rate of 1 Å/s in the thermal evaporator, thereby manufacturing an organic solar cell.

### Example 2. Manufacture of Organic Solar Cell

An organic solar cell was manufactured in the same manner as in Example 1, except that Compound 2 was used instead of Compound 1 in Example 1.

### Example 3. Manufacture of Organic Solar Cell

An organic solar cell was manufactured in the same manner as in Example 1, except that Compound 3 was used instead of Compound 1 in Example 1.

### Example 4. Manufacture of Organic Solar Cell

An organic solar cell was manufactured in the same manner as in Example 1, except that Compound 4 was used instead of Compound 1 in Example 1.

### Example 5. Manufacture of Organic Solar Cell

An organic solar cell was manufactured in the same manner as in Example 1, except that Compound 5 was used instead of Compound 1 in Example 1.

### Example 6. Manufacture of Organic Solar Cell

An organic solar cell was manufactured in the same manner as in Example 1, except that Compound 6 was used instead of Compound 1 in Example 1.

### Example 7. Manufacture of Organic Solar Cell

An organic solar cell was manufactured in the same manner as in Example 1, except that Compound 7 was used instead of Compound 1 in Example 1.

### Example 8. Manufacture of Organic Solar Cell

An organic solar cell was manufactured in the same manner as in Example 1, except that Compound 8 was used instead of Compound 1 in Example 1.

### Example 9. Manufacture of Organic Solar Cell

An organic solar cell was manufactured in the same manner as in Example 1, except that Compound 9 was used instead of Compound 1 in Example 1.

### Example 10. Manufacture of Organic Solar Cell

An organic solar cell was manufactured in the same manner as in Example 1, except that Compound 10 was used instead of Compound 1 in Example 1.

The photoelectric conversion characteristics of the organic solar cells manufactured in Examples 1 to 10 were measured under the condition of 100 mW/cm² (AM 1.5), and the results are shown in the following Table 1.

**[Table 1]**

| | | V_{oc} (V) | J_{sc} (mA/cm²) | FF (%) | η (%) |
|---|---|---|---|---|---|
| | Example 1 | 0.860 | 7.453 | 0.312 | 2.00 |
| | Example 2 | 0.821 | 6.568 | 0.310 | 1.67 |
| | Example 3 | 0.942 | 4.189 | 0.355 | 1.40 |
| * | Example 4 | 0.871 | 7.960 | 0.347 | 2.40 |
| | Example 5 | 0.869 | 9.195 | 0.330 | 2.64 |
| * | Example 6 | 0.656 | 12.28 | 0.53 | 4.30 |
| | Example 7 | 0.663 | 11.97 | 0.47 | 3.76 |
| * | Example 8 | 0.648 | 9.81 | 0.60 | 3.83 |
| | Example 9 | 0.645 | 11.38 | 0.55 | 4.07 |
| * | Example 10 | 0.655 | 11.21 | 0.53 | 3.86 |

| | | | | | |
|---|---|---|---|---|---|
| * indicates a Reference Example not in accordance with the present invention. | | | | | |

In Table 1, V_{oc}, J_{sc}, FF, and η mean an open-circuit voltage, a short-circuit current, a fill factor, and energy conversion efficiency, respectively. The open-circuit voltage and the short-circuit current are an X axis intercept and a Y axis intercept, respectively, in the fourth quadrant of the voltage-current density curve, and as the two values are increased, the efficiency of the solar cell is preferably increased. In addition, the fill factor is a value obtained by dividing the area of a rectangle, which may be drawn within the curve, by the product of the short-circuit current and the open-circuit voltage. The energy conversion efficiency may be obtained when these three values are divided by the intensity of the irradiated light, and the higher value is preferred.

FIG. 8 illustrates a current density according to a voltage with respect to organic solar cells manufactured in exemplary embodiments of the present specification.

## Claims

1. A compound represented by any one of the following Formulae 1-11 to 1-13 and 1-15: 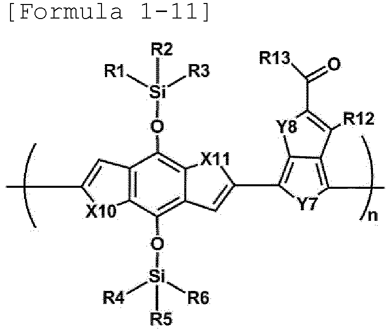 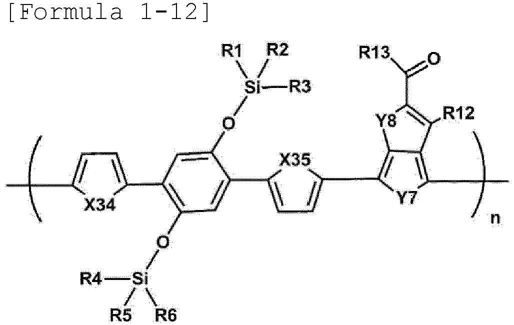 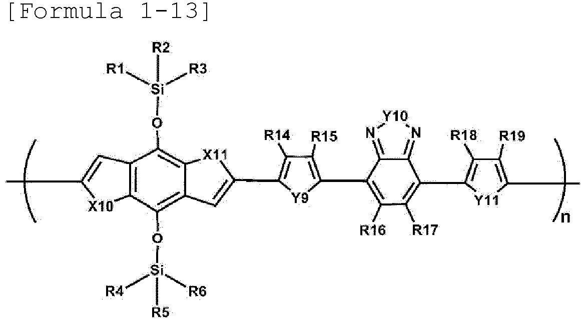 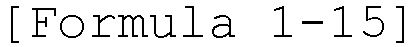 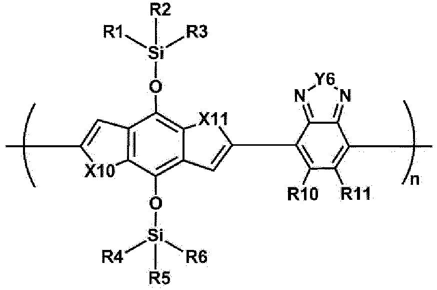 wherein:
R1 to R6 are the same as or different from each other, and are each independently an alkyl group,
X10, X11, X34, X35, and Y6 to Y11 are the same as or different from each other, and are each independently S, O, Se, Te, NR, CRR', SiRR', PR', or GeRR',
R10 to R19, R, and R' are the same as or different from each other, and are each independently hydrogen; deuterium; a halogen group; a nitrile group; a nitro group; a hydroxyl group; a carbonyl group; an ester group; an imide group; an amide group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted amine group; a substituted or unsubstituted arylphosphine group; a substituted or unsubstituted phosphine oxide group; a substituted or unsubstituted aryl group; or a substituted or unsubstituted heterocyclic group, and
n is an integer from 1 to 10,000.

2. An organic solar cell comprising:
a first electrode (102);
a second electrode (105) provided to face the first electrode; and
an organic material layer having one or more layers provided between the first electrode and the second electrode and comprising a photoactive layer (104),
wherein one or more layers of the organic material layer comprise the compound according to Claim 1.

3. The organic solar cell according to Claim 2, wherein the organic material layer comprises a hole transport layer, a hole injection layer, or a layer which simultaneously transports and injects holes, and
the hole transport layer, the hole injection layer, or the layer which simultaneously transports and injects holes comprises the compound.

4. The organic solar cell according to Claim 2, wherein the organic material layer comprises an electron injection layer, an electron transport layer or a layer which simultaneously injects and transports electrons, and
the electron injection layer, the electron transport layer or the layer which simultaneously injects and transports electrons comprises the compound.

5. The organic solar cell according to Claim 2, wherein the photoactive layer comprises an electron donor and an electron acceptor, and
the electron donor comprises the compound.

6. The organic solar cell according to Claim 2, wherein the organic solar cell further comprises one or two or more organic material layers selected from the group consisting of a hole injection layer, a hole transport layer, a hole blocking layer, a charge generation layer, an electron blocking layer, an electron injection layer, and an electron transport layer.

## Patentansprüche

1. Verbindung, die durch eine beliebige der folgenden Formeln 1-11 bis 1-13 und 1-15 dargestellt ist: 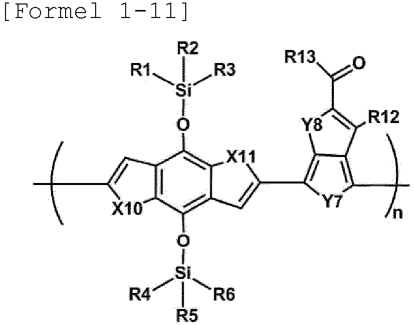 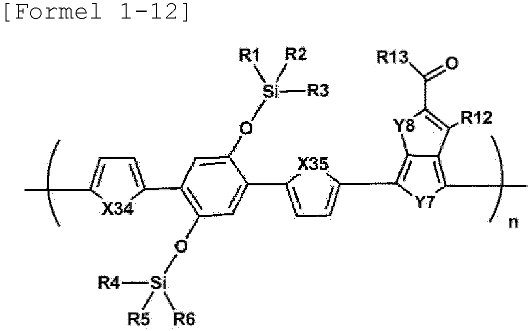 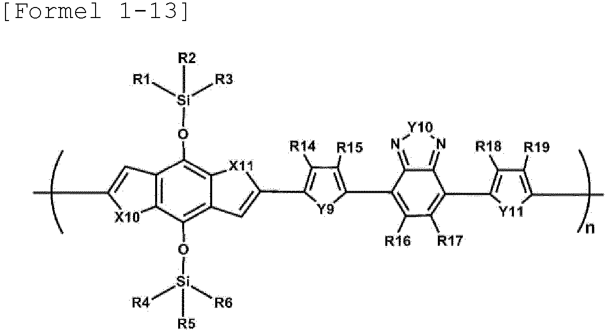 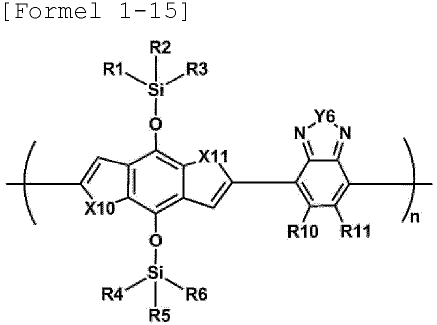 worin:
R1 bis R6 gleich oder verschieden sind und jeweils unabhängig eine Alkylgruppe darstellen,
X10, X11, X34, X35 und Y6 bis Y11 gleich oder verschieden sind und jeweils unabhängig S, O, Se, Te, NR, CRR', SiRR', PR' oder GeRR' darstellen,
R10 bis R19, R und R' gleich oder verschieden sind und jeweils unabhängig Wasserstoff; Deuterium; eine Halogengruppe; eine Nitrilgruppe; eine Nitrogruppe; eine Hydroxylgruppe; eine Carbonylgruppe; eine Estergruppe; eine Imidgruppe; eine Amidgruppe; eine substituierte oder unsubstituierte Alkylgruppe; eine substituierte oder unsubstituierte Cycloalkylgruppe; eine substituierte oder unsubstituierte Alkoxygruppe; eine substituierte oder unsubstituierte Aryloxygruppe; eine substituierte oder unsubstituierte Alkylthioxygruppe; eine substituierte oder unsubstituierte Arylthioxygruppe; eine substituierte oder unsubstituierte Alkylsulfoxygruppe; eine substituierte oder unsubstituierte Arylsulfoxygruppe; eine substituierte oder unsubstituierte Alkenylgruppe; eine substituierte oder unsubstituierte Silylgruppe; eine substituierte oder unsubstituierte Borgruppe; eine substituierte oder unsubstituierte Amingruppe; eine substituierte oder unsubstituierte Arylphosphingruppe; eine substituierte oder unsubstituierte Phosphinoxidgruppe; eine substituierte oder unsubstituierte Arylgruppe; oder eine substituierte oder unsubstituierte heterocyclische Gruppe sind, und
n eine ganze Zahl von 1 bis 10.000 ist.

2. Organische Solarzelle, umfassend:
eine erste Elektrode (102);
eine zweite Elektrode (105), die der ersten Elektrode gegenüberliegt; und
eine organische Materialschicht mit einer oder mehreren Schichten, die zwischen der ersten Elektrode und der zweiten Elektrode angeordnet sind und eine photoaktive Schicht (104) umfassen,
wobei eine oder mehrere Schichten der organischen Materialschicht die Verbindung gemäß Anspruch 1 umfassen.

3. Organische Solarzelle gemäß Anspruch 2, wobei die organische Materialschicht eine Lochtransportschicht, eine Lochinjektionsschicht oder eine Schicht, die gleichzeitig Löcher transportiert und injiziert, umfasst, und
die Lochtransportschicht, die Lochinjektionsschicht oder die Schicht, die gleichzeitig Löcher transportiert und injiziert, die Verbindung umfasst.

4. Organische Solarzelle gemäß Anspruch 2, wobei die organische Materialschicht eine Elektroneninjektionsschicht, eine Elektronentransportschicht oder eine Schicht, die gleichzeitig Elektronen injiziert und transportiert, umfasst, und
die Elektroneninjektionsschicht, die Elektronentransportschicht oder die Schicht, die gleichzeitig Elektronen injiziert und transportiert, die Verbindung umfasst.

5. Organische Solarzelle gemäß Anspruch 2, wobei die photoaktive Schicht einen Elektronendonor und einen Elektronenakzeptor umfasst, und
der Elektronendonor die Verbindung umfasst.

6. Organische Solarzelle gemäß Anspruch 2, wobei die organische Solarzelle ferner eine oder zwei oder mehr organische Materialschichten umfasst, ausgewählt aus der Gruppe bestehend aus einer Lochinjektionsschicht, einer Lochtransportschicht, einer Lochsperrschicht, einer Ladungserzeugungsschicht, einer Elektronensperrschicht, einer Elektroneninjektionsschicht und einer Elektronentransportschicht.

## Revendications

1. Composé représenté par l'une quelconque des Formules 1-11 à 1-13 et 1-15 suivantes : 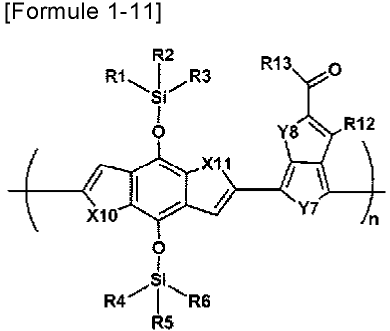 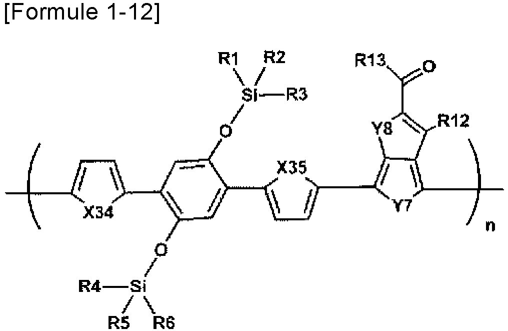 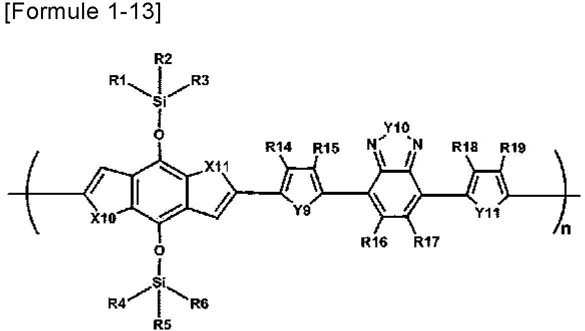 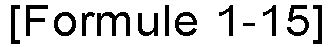 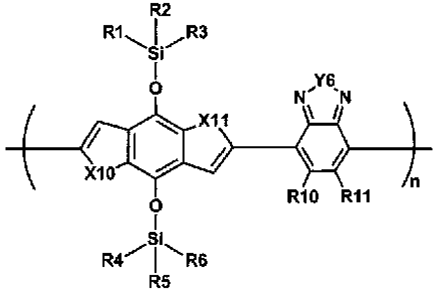 dans lequel :
R1 à R6 sont identiques ou différents l'un de l'autre, et sont chacun indépendamment un groupe alkyle,
X10, X11, X34, X35, et Y6 à Y11 sont identiques ou différents l'un de l'autre, et sont chacun indépendamment S, O, Se, Te, NR, CRR', SiRR', PR', ou GeRR', R10 à R19, R, et R' sont identiques ou différents l'un de l'autre, et sont chacun indépendamment hydrogène ; deutérium ; un groupe halogène ; un groupe nitrile ; un groupe nitro ; un groupe hydroxyle ; un groupe carbonyle ; un groupe ester ; un groupe imide ; un groupe amide ; un groupe alkyle substitué ou non substitué ; un groupe cycloalkyle substitué ou non substitué ; un groupe alcoxy substitué ou non substitué ; un groupe aryloxy substitué ou non substitué ; un groupe alkylthioxy substitué ou non substitué ; un groupe arylthioxy substitué ou non substitué ; un groupe alkylsulfoxy substitué ou non substitué ; un groupe arylsulfoxy substitué ou non substitué ; un groupe alcényle substitué ou non substitué ; un groupe silyle substitué ou non substitué ; un groupe de bore substitué ou non substitué ; un groupe amine substitué ou non substitué ; un groupe arylphosphine substitué ou non substitué ; un groupe oxyde de phosphine substitué ou non substitué ; un groupe aryle substitué ou non substitué ; ou un groupe hétérocyclique substitué ou non substitué, et
n est un nombre entier compris entre 1 et 10 000.

2. Cellule solaire organique comprenant :
une première électrode (102) ;
une seconde électrode (105) prévue de manière à faire face à la première électrode ;
et
une couche de matériau organique présentant une ou plusieurs couches prévues entre la première électrode et la seconde électrode et comprenant une couche photoactive (104),
dans laquelle une ou plusieurs couches de la couche de matériau organique comprend le composé selon la revendication 1.

3. Cellule solaire organique selon la revendication 2, dans laquelle la couche de matériau organique comprend une couche de transport de trous, une couche d'injection de trous, ou une couche qui transporte et injecte simultanément des trous, et la couche de transport de trous, la couche d'injection de trous, ou la couche qui transporte et injecte simultanément des trous comprend le composé.

4. Cellule solaire organique selon la revendication 2, dans laquelle la couche de matériau organique comprend une couche d'injection d'électrons, une couche de transport d'électrons ou une couche qui injecte et transporte simultanément des électrons, et
la couche d'injection d'électrons, la couche de transport d'électrons ou la couche qui injecte et transporte simultanément des électrons comprend le composé.

5. Cellule solaire organique selon la revendication 2, dans laquelle la couche photoactive comprend un donneur d'électrons et un accepteur d'électrons, et
le donneur d'électrons comprend le composé.

6. Cellule solaire organique selon la revendication 2, dans laquelle la cellule solaire organique comprend une ou deux ou plusieurs couches de matériau organique choisies dans le groupe consistant en une couche d'injection de trous, une couche de transport de trous, une couche de blocage de trous, une couche de génération de charge, une couche de blocage d'électrons, une couche d'injection d'électrons, et une couche de transport d'électrons.
